# EUROPÄISCHE PATENTANMELDUNG

(11) **EP 1 233 272 A1**
(43) Veröffentlichungstag der Anmeldung: **21.08.2002**
(21) Anmeldenummer: 01103973.2
(22) Anmeldetag: 19.02.2001
(51) Int. Cl.: G01R 3/00, B29C 67/00, G01R 1/073

(54) **Verfahren zur Herstellung eines Vollmaterialadapters aus einem mit Licht aushärtbaren Photopolymer**

(71) Anmelder: MANIA GmbH & Co., 61276 Weilrod (DE)
(72) Erfinder: Pfeil, Frank, 60327 Frankfurt (DE); Mang, Paul, 61389 Schmitten (DE)
(74) Vertreter: Ruschke, Hans Edvard, Dipl.-Ing.

(57) **Zusammenfassung**

Verfahren zur Herstellung eines Adapters zur Anpassung des gleichmäßigen Kontaktrasters einer elektrischen Prüfvorrichtung für Leiterplatten an die ugleichmäßige Kontaktkonfiguration der Anschlußpunkte auf einer ein- oder beiseitig zu prüfenden Leiterplatte mit nadelartigen Prüfstiften, die mit ihrem Ende auf den regelmäßig verteilten Kontakten des Kontaktfeldes der Prüfvorrichtung aufliegen, sich durch die Prüfstiftkanäle des Adapterkörpers erstrecken und mit ihren anderen Enden die meistens unregelmäßig verteilten Anschlußpunkte der zu prüfenden Leiterplatte kontaktieren, wobei die Deckfläche des Adapterköpers an der zu kontaktierenden Fläche der Leiterplatte und die Bodenfläche des Adapterkörpers auf dem Kontaktfeld der Prüfvorrichtung anliegt und der Adaterkörper im Bereich zwischen seiner Bodenfläche und seiner Deckfläche durchgängig von den Prüfstiftkanälen durchsetzt ist, dadurch gekennzeichnet, daß der Adapterkörper mit allen darin erforderlichen Prüfstiftkanälen schichtweise von unten nach oben (oder umgekehrt) aufgebaut wird aus einem Bad eines zunächst flüssigen, aber durch Licht aushärtbaren Photopolymers, wobei die Oberfläche des Bades von einer Lichtquelle in ausgewählten Bereichen belichtet und ausgehärtet wird, und daß diese Schritte sukzessive wiederholt werden, bis alle Schichten des vollständigen Adapters mit sämtlichen, womöglich schräg oder gekrümmt verlaufenden Prüfstiftkanälen aufgebaut sind.

## Beschreibung

Die vorliegende Erfindung betrifft ein Verfahren zur Herstellung eines Adapters zur Anpassung des gleichmäßigen Kontaktrasters einer elektronischen Prüfvorrichtung für Leiterplatten an die ungleichmäßige Kontaktkonfiguration der Anschlußpunkte auf einer zu prüfenden Leiterplatte, gemäß dem Oberbegriff des Patentanspruches 1.

Der sogenannte "Universaladapter" der Anmelderin gemäß der EP 26 824 B1 weist eine auf dem Grundraster der Prüfvorrichtung aufliegende Grundplatte auf, die entsprechend dem gleichmäßigen Kontaktraster der Prüfvorrichtung mit durchgehenden Kanälen oder Bohrungen versehen ist. In einiger Entfernung über dem Grundraster, d.h. auf der vom Grundraster der Prüfvorrichtung abgewandten Seite der Grundplatte wird eine Anordnung aus von zwei zueinander beabstandeten Adapterplatten mit Hilfe von festen Abstandshaltern angeordnet. Diese Adapterplatten sind identisch mit Bohrungen versehen, die entsprechend den variabel angeordneten Anschlußpunkten der zu prüfenden Leiterplatte verteilt sind. In diese Bohrungen in den Adapterplatten werden dann nadelförmige, in Längsrichtung federnde Prüfstifte eingesetzt, die zum Ausgleich von eventuellen Fluchtungsfehlern zwischen den genannten prüflingsspezifischen Bohrungen und den rastergebundenen Kanälen zumindest in ihrem unteren Abschnitt quer zur Längserstreckung der Prüfstifte federnd auslenkbar sind. Bei einem solchen, aus mehreren Platten aufgebauten Adapter muß der Leiterplattenhersteller zumindest die prüflingsspezifischen Adapterplatten für jede Testserie speziell anfertigen, um den Adapter überhaupt aufbauen zu können, d.h. eine Rationalisierung ist bei der Adapterfertigung insoweit nicht möglich.

Da bei komplexen Leiterplatten viele tausend Anschlußpunkte vorgesehen sein können und für jeden Anschlußpunkt ein Prüfstift benötigt wird, steigen die Kosten für einen solchen Adapter mit der Zahl der Anschlußpunkte stark an, da in Längsrichtung federnde Prüfstifte einen nicht unerheblichen Fertigungsaufwand erfordern. Es kommt hinzu, daß solche Prüfstifte, selbst wenn sie als Starrstifte ausgebildet sind; aus Festigkeitsgründen einen kaum zu unterschreitenden Mindestdurchmesser haben müssen, der die natürliche Grenze für die mögliche Prüfstiftdichte darstellt.

Um in Längsrichtung starre und somit einfach herzustellende und besonders dünne Prüfstifte verwenden zu können, wurde ein "aktives Grundraster" geschaffen, bei dem die Kontakte des Grundrasters der Leiterplattenprüfvorrichtung im wesentlichen in Richtung der Längsachse der Prüfstifte federnd gelagert sind. Dieses aktive Grundraster wird auf das starre, fest verdrahtete Grundraster der Leiterplattenprüfvorrichtung aufgesetzt und dient dazu, bei der Verwendung von starren Prüfstiften für einen ausreichend hohen und möglichst gleichmäßigen Kontaktdruck bei allen von den starren Prüfstiften kontaktierten Prüfpunkten zu sorgen.

Die EP-A1-0 215 146 zeigt MANIAs "Adapter 85", dessen obere prüflingsspezifisch gebohrte Adapterplatte an der zu prüfenden Leiterplatte anliegt und dessen starre konturlosen Prüfstifte eine im Abstand darunter angeordnete zusätzliche elastische Matte durchsetzen, die ungebohrt ist und aufgrund der Elastizität des Materials die Prüfstifte beim Hantieren mit dem Adapter unabhängig von der eigentlichen Prüfvorrichtung am Herausfallen hindern. Dadurch kann bei einer späteren Prüfung von gleichen Leiterplatten der nicht unerhebliche Arbeitsaufwand zum Bestücken des Adapters mit Prüfstiften gespart und statt dessen der Adapter bis zu erneuten Verwendung wieder aufbewahrt werden. Dieser Adapter bringt zwar den Vorteil, daß sehr billig herzustellende starre und völlig konturlose Prüfstifte verwendet werden können, doch wird die Bestückung des Adapters dadurch kompliziert, daß die Prüfstifte nicht einfach in den Adapter "hineinfallen" können, sondern durch die elastische ungebohrte Matte mit einem gewissen Kraftaufwand hindurchgedrückt werden müssen. Weiterhin weist dieser Adapter eine innere Adapterplatte auf, deren Raster jedoch weder dem Raster der äußeren Adapterplatte noch dem der Grundplatte entspricht. Dies bedeutet also, daß neben der prüfungsspezifisch gebohrten Adapterplatte mindestens eine weitere Adapterplatte mit einem Bohrungsmuster hergestellt werden muß, das von demjenigen der erstgenannten Adapterplatte abweicht.

Es gibt weitere Adapterbauformen, bei denen eine ganze Reihe von gebohrten Adapterplatten zwischen der prüflingsspezifisch gebohrten Adapterplatte und der auf dem Kontaktpunktraster des Prüfgerätes aufliegenden Rasterlochplatte des Adapters angeordnet sind. Die Bohrungsmuster der dazwischenliegenden Adapterplatten schaffen einen allmählichen Übergang von der prüflingsspezifisch gebohrten Adapterplatte zu der Rasterlochplatte und sind daher jeweils unterschiedlich, erfordern also einen höheren Fertigungs- und Materialaufwand bei der Herstellung solcher Adapter; zudem ist das Bestücken solcher Adapter mit den erforderlichen Prüfstiften besonders schwierig.

Die voranstehend abgehandelten Adapter sind für die einseitige Prüfung von Leiterplatten konzipiert worden. Es kommen jedoch zunehmend Leiterplatten zum Einsatz, die beidseitig mit Anschlußpunkten versehen sind, d.h. die Leiterplatten müssen auch von beiden Seiten geprüft werden. Dabei kann man sich zwar mit zwei aufeinanderfolgenden einseitigen Prüfungen behelfen, doch wird man dabei jedenfalls keine Leitungsunterbrechungen bei sogenannten "Durchsteigern" feststellen können, die zudem im Hinblick auf Leitungsunterbrechungen besonders empfindlich sind. Daher sind Leiterplattenprüfvorrichtungen entwickelt worden, die in der Lage sind, eine gleichzeitige beidseitige Prüfung von doppelseitig bestückbaren Leiterplatten vorzunehmen. Dies führt dann auch zur Notwendigkeit von Adaptern für derartige Prüfvorrichtungen. Leider sind viele Adapter nur in Ausnahmefällen für die gleichzeitige beidseitige Prüfung verwendbar, denn wenn die Anschlußpunkte auf beiden Seiten der zu prüfenden Leiterplatte ungleichmäßig verteilt sind, kommt es bei den bisweilen vielen tausend Prüfstiften zu erheblichen Verformungen bzw. Verwerfungen des Prüflings, was zu zusätzlichen (neuen) Fehlern in den Leiterbahnen oder gar zum Bruch der Leiterplatte führen kann - letzteres insbesondere bei Keramikplatten. Bei einer einseitigen Prüfung von Leiterplatten kann eine ungleichmäßige Verteilung oder örtliche Konzentrierung von Prüfstiften nicht zu einem solchen nachteiligen Effekt führen, weil das Widerlager auf der anderen Seite des Prüflings eine stabile Platte der eigentlichen Prüfvorrichtung sein kann, wobei diese Platte alle ungleichmäßigen Krafteinleitungen in die Leiterplatte im wesentlichen ohne Verwerfungen aufnimmt und somit die zu prüfende Leiterplatte in einem weitgehend unverformten Zustand abstützt. Bei einer gleichzeitig zweiseitigen Prüfung von Leiterplatten ist dies jedoch nicht möglich, weil das Widerlager bei lokal begrenzt fehlenden Prüfstifte auf der anderen Seite des Prüflings somit entweder nicht vorhanden ist oder die prüflingsspezifisch gebohrte Adapterplatte des anderen Adapters ist, wobei diese Adapterplatte nicht beliebig starr gemacht werden kann, zumal sie häufig aus Acrylglas oder dergleichen hergestellt wird, um den manuellen Bestückungsvorgang des Adapters zu erleichtern.

Das Problem des eventuell örtlich fehlenden Widerlagers und der damit lokal zu hohen Krafteinleitung in die zu prüfende Leiterplatte bei gleichzeitig beidseitiger Prüfung derselben wird bei MANIAs "Adapter 87" nach der EP 0 315 707 dadurch behoben, daß zusätzliche Abstützmittel in den Adapter an den besonders beanspruchten Stellen eingeführt werden, z.B. in Form von separaten federnden Stützstiften.

Angesichts der im Zuge der Miniaturisierung von Leiterplatten oder Verdrahtungsträgern weiter zunehmenden Dichte der Anschlußflächen der zu prüfenden Leiterplatten wird es aber immer schwieriger, den notwendigen Platz für diese Stützstifte zwischen den eigentlichen Prüfstiften vorzusehen. Es kommt hinzu, daß das Herstellen und Einbringen der Stützstifte in einen Adapter einen nicht unerheblichen zusätzlichen Fertigungsaufwand darstellt.

Es gibt Adapteranordnungen, bei denen federnde Prüfstifte (US-PS 3,654,585) bzw. biegeelastische Drahtstückchen (EP 184 619) mit vergleichbarer Funktion parallel zueinander in einem im wesentlichen starren bzw. zusammendrückbaren Massivkörper, d.h. einer sogenannten "Vertikalleiterplatte" angeordnet sind, doch wird dabei die eigentliche Übersetzung oder Adaptierung zwischen den ungleichmäßig angeordneten prüflingsorientierten Kontaktpunkten und den streng rasterförmig angeordneten Kontakten des Prüfgerätes durch eine zusätzliche "transition plate" bzw. "Umsetzerplatte" bewerkstelligt, die nach üblichen Leiterplattentechniken mit gegeneinander versetzten Kontaktflächen auf beiden Plattenoberflächen versehen sind. Diese Adapteranordnungen erfordern also einen erhöhten Fertigungsaufwand allein schon durch das Erfordernis der sogenannten "Umsetzer- oder Adapterplatte".

Um einen kostengünstig herzustellenden, für die beidseitige Prüfung von Leiterplatten hoher Kontaktdichte zu verwendenden Adapter vorzusehen, wird in MANIAs "Vollmaterialadapter" nach der EP 708 926 B1 vorgeschlagen, daß der Adapter im Bereich zwischen seiner Bodenfläche und seiner Deckfläche ein im wesentlichen inkompressibler Vollmaterialkörper geringer Dichte und hoher Flächendruckfestigkeit wie z.B. Styropor ist, der durchgängig von den Prüfstiftkanälen durchsetzt ist, die durch das Einstecken von geeignet dimensionierten Nadeln z.B. mit Hilfe eines bekannten "Prüfstiftsetzers" erzeugt werden. Die Notwendigkeit zum vorbereitenden Bohren mehrerer Adapterplatten mit unterschiedlichen Bohrmustern entfällt hierdurch vollkommen und zugleich wird jede(r) zu prüfende Leiterplatte/Verdrahtungsträger auf seiner gesamten Fläche überall gleichmäßig unterstützt, so daß eine lokale Massierung von Prüfstiften auf der einen Seite des Prüflings selbst ohne eine entsprechende Massierung von Prüfstiften oder ohne zusätzliche Stützstifte auf der anderen Seite des Prüflings nicht zu Problemen im Hinblick auf eine zu große Krafteinleitung in den Prüfling führt.

Diese Art der Herstellung eines "Vollmaterialadapters" durch Einstecken von Nadeln in ein geeignetes Material z.B. mit Hilfe eines sogenannten "Prüfstiftsetzers" ist aber nur bis zu solchen Nadelstärken möglich, die eine ausreichende Eigenstabilität aufweisen. Bei besonders feinen und/oder zahlreichen bzw. dicht angeordneten Prüfstiftkanälen kommt man an die Grenzen dieses bekannten Verfahrens und muß sich nach alternativen Fertigungsmethoden umsehen.

Angesichts der immer weiter getriebenen Miniaturisierung bei der Herstellung von Leiterplatten oder PCBs bzw. "Schaltungsträgern" ergibt sich die Notwendigkeit, immer dünnere Teststifte einzusetzen, um solche Schaltungsträger auch zukünftig testen zu können. Aber je dünner die zu verwendenden Prüfstifte gemacht werden, desto besser müssen sie innerhalb des Adapters geführt werden, damit sie nicht ausknicken: Bei einem Plattenadapter bedeutet dies zusätzliche Führungsplatinen, was wiederum mehr Bohrarbeit zum Erstellen derselben erfordert.

Hiernach ist es eine Aufgabe der vorliegenden Erfindung, ein Herstellungsverfahren für Prüfstift-Adapter (engl.: "test-fixtures") anzugeben, das vom Ansatz her keine Miniaturisierungsgrenzen kennt.

Nach der vorliegenden Erfindung wird diese Aufgabe grundsätzlich dadurch gelöst, daß der Adapterkörper mit allen darin erforderlichen Prüfstiftkanälen schichtweise von unten nach oben (oder umgekehrt) aufgebaut wird aus einem Bad eines zunächst flüssigen, aber durch Licht aushärtbaren Photopolymers, wobei die Oberfläche des Bades von einer Lichtquelle in ausgewählten Bereichen belichtet und augehärtet wird, und daß diese Schritte sukzessive wiederholt werden, bis alle Schichten des vollständigen Adapters mit sämtlichen, womöglich schräg oder gekrümmt verlaufenden Prüfstiftkanälen aufgebaut sind. Die Anmelderin nennt diese Methode das Stereo-Lithographie-Verfahren, kurz STL-Verfahren.

In einer möglichen Ausgestaltung dieses grundsätzlichen Verfahrens wird der Adapterkörper schichtweise (vorzugsweise mit Schichtdicken von 100-200 µm) von unten nach oben (oder umgekehrt) aus einem Bad eines zunächst flüssigen, aber durch Licht aushärtbaren Photopolymers aufgebaut, dessen Oberfläche von einer geeigneten Lichtquelle durch eine selektiv wirkende erste Photomaske hindurch belichtet und ausgehärtet wird, die der (jeweiligen) ersten Querschnittsfläche des Adapterkörpers einschließlich aller Prüfstiftkanäle (und eventueller Aussparungen, etwa zur Gewichtseinsparung) entspricht, wonach mittels einer zweiten Photomaske die nächstfolgende Schicht auf der vorhergehenden ersten Schicht belichtet und ausgehärtet wird, wobei die zweite Photomaske sich von der ersten Photomaske insbesondere in der Position der Prüfstiftkanäle und der eventuellen Aussparungen unterscheiden kann, und daß diese Schritte sukzessive wiederholt werden, bis alle (z.B. horizontalen) Schichten des vollständigen Adapters mit seinen womöglich schräg oder nahezu beliebig dreidimensional verlaufenden Prüfstiftkanälen aufgebaut sind. Andere Möglichkeiten der Belichtung und Aushärtung sind denkbar, so z.B. mit Hilfe eines in geeigneter Weise (z.B. über Ablenkspiegel) gesteuerten Laserstrahls.

Eine vorteilhafte Ausgestaltung des erfindungsgemäßen Verfahrens sieht vor, daß, um die Produktionszeit zu verkürzen, nicht das volle Volumen der zweiten Schicht ausgehärtet wird, wie dies vorangehend schon angedeutet wurde. Stattdessen wird innerhalb des Adapters eine zusätzliche Wabenstruktur hergestellt, die ausreichend Stabilität aufweist. Der Zeit- und Kostengewinn aufgrund der Ausbildung der Wabenstruktur ist enorm, da das ausgehärtete Massevolumen mit der 3. Potenz in die Produktionszeit einfließt. In dieser Wabenstruktur eingebettet befinden sich die röhrenförmigen Strukturen, welche die Prüfstifte aus Metall oder, als Alternative dazu, aus (zunächst fließfähigem) leitfähigem Material wie aushärtbarem leitfähigen Kunststoff aufnehmen und führen. Der jeweilige Prüfstift bzw. das leitfähige Material würde wie in einem Tunnel, der in diese Wabenstruktur eingebettet ist, geführt. Die röhrenförmigen Strukturen müssen nicht gerade sein, sondern können jede beliebige Freiform aufnehmen. Beim Einsatz von Prüfstiften aus Metall sind dem logischerweise mechanische Grenzen gesetzt.

Als besonders vorteilhaft erweist es sich dabei, wenn jede der Photomasken von einem LCD (Liquid Crystal Device) gebildet wird, welcher von einem Rechner gesteuert ist zum sukzessiven Errechnen der höhenabhängigen jeweiligen Position der Querschnittsfläche eines jeden Prüfstiftkanals und eventueller Aussparungen etwa zur Gewichtseinsparung in der jeweiligen Schicht bei schief verlaufenden Prüfstiftkanälen des Adapters.

Mit Hilfe der voranstehenden Techniken der sogenannten "Stereo-Lithographie" gelingt es, Adapter von fast beliebiger Komplexität und Miniaturisierung herzustellen, um so alle Anforderungen der Adaptertechnik beim Prüfen von Leiterplatten mit Prüfstiftadaptern zu erfüllen. Die verwendeten Prüfstifte werden über die ganze Länge geführt, d.h. ein Ausknicken der Stifte ist somit nicht möglich.

Zum Kontaktieren der zu prüfenden Boards können normale Testpins ohne Verdickung zum Einsatz kommen. Die Reibung zwischen Stift und Innenwand der Röhre reicht in der Regel aus, um den Stift zu halten; damit können die Stifte leicht in den ausgehärteten Polymer eingeführt werden.

Eine mögliche Variante, um die Stifte im Adapter zu halten, könnte eine Verdikkung an den Stiften sein, mit der jeder Stift jeweils zwischen einer zusätzlichen gebohrten Platte und dem STL-Adapter oder zwischen zwei zusätzlich gebohrten Platten gehalten wird, wie dies an sich im Stand der Technik bekannt ist. Eine weitere Variante zu diesem Zweck kann eine eingelegte gummi-elastische Matte sein, welche von den Prüfstiften durchsetzt wird und so die Stifte festhält. Auch eine genügend enge Führung der Stifte in dem STL-Adapter ist denkbar, so daß die Reibung den Stift in Position hält. Ein flüssiges bzw. zähflüssiges Material, welches den elektrischen Kontakt machen soll, wird sich allein aufgrund der Oberflächenreibung im Adapter halten.

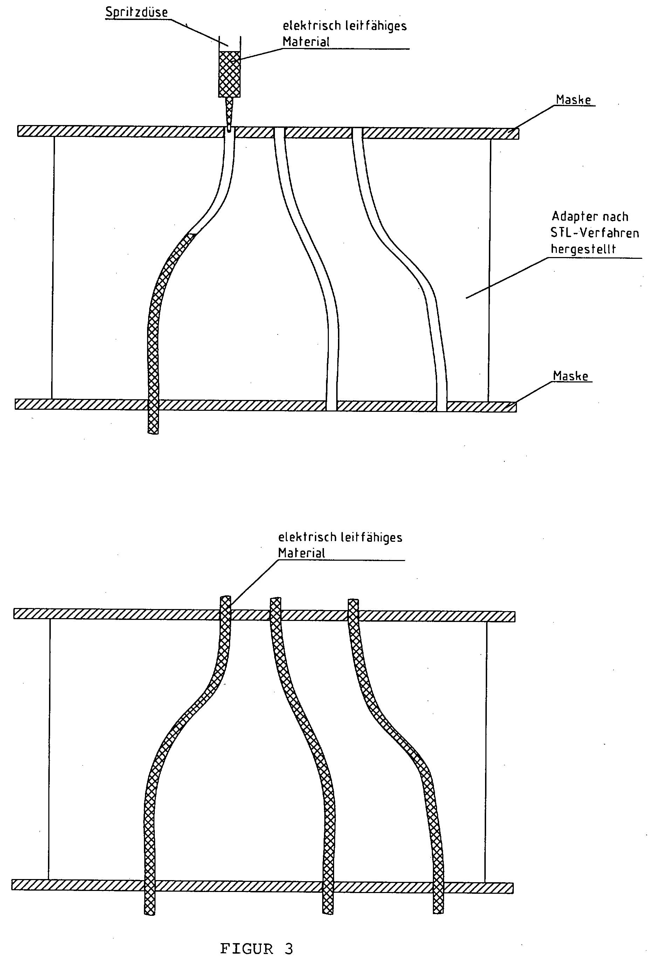

Um den nötigen Überstand der Prüfstifte über den STL-Adapter zu erreichen, damit das Board bzw. das Grid des Testers sicher kontaktiert wird, kann man entsprechende Masken auf den Adapter aufbringen. Diese werden nach dem Aushärten des elektrisch-leitfähigen Kontaktmaterials wieder entfernt und haben die Dicke entsprechend dem notwendigen Überstand (siehe beigefügte Figur 3).

Ein Nachbearbeiten der STL-Adapteroberfläche ist denkbar. Für eine exakte Auflage des Prüflings bzw. des Adapters auf dem Testfeld kann eine zusätzliche, gebohrte Platte für beide Seiten des Adapters hilfreich sein. Die Schichtstruktur ― Sägezahn auf der Oberfläche ― tritt sowieso nur an den Seitenflächen auf, ein Nachschleifen hätte keinen Einfluß auf die Funktionalität, sondern würde nur das äußere Erscheinungsbild verbessern.

Zwei Ausführungsbeispiele der vorliegenden Erfindung werden unter Bezugnahme auf die beigefügten Zeichnungen beschrieben. Darin zeigt, jeweils in prinzipieller Darstellung,
- Fig. 1: eine erste Ausführungsform des erfindungsgemäßen Verfahrens, bei dem Licht durch eine rechnergesteuerte Photomaske in ein Photopolymer-Bad fällt;
- Fig. 2: eine zweite Ausführungsform des erfindungsgemäßen Verfahrens, bei dem ein Laserstrahl durch Ablenkspiegel gesteuert in ein Photopolymer-Bad fällt;
- Fig. 3: eine Möglichkeit zur Ausbildung der stromführenden Bahnen in dem nach dem erfindungsgemäßen Verfahren hergestellten Adapter.

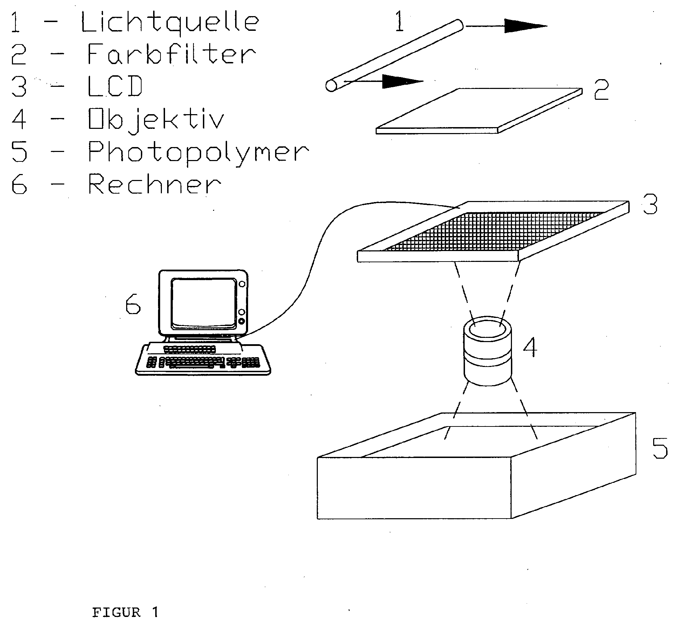

Die Funktionsweise der ersten Ausführungsform des Mikro-Stereolithographie-Verfahrens wird anhand der beigefügten Prinzipskizze der Fig. 1 erläutert. Eine stabförmige Lampe 1 (z.B. Halogenglühlampe) erzeugt durch ein Farbfilter 2 hindurch die notwendige Strahlung. Die homogene Ausleuchtung des als rechnergesteuerte Photomaske 3 dienenden LCDs wird erreicht, indem die Lampe 1 in einer Translationsbewegung senkrecht zu ihrer Längsachse und parallel zur Längsseite des als Photomaske 3 wirkenden LCDs über dessen Querschnitt bewegt wird. Dieser Vorgang kann mit dem Belichtungsvorgang herkömmlicher Kopiergeräte verglichen werden. Weil der Kontrast des LCDs (Verhältnis von Helltransmission zu Dunkeltransmission) stark von der Wellenlänge der Bestrahlung abhängt, kann ein spezieller Farbfilter 2 zur Bandbegrenzung der Strahlung notwendig sein. Das LCD wird von einem Mikrorechner gesteuert und erzeugt das Muster des Querschnitts der zu belichtenden Schicht, also des gewünschten ersten Querschnitts eines Plattenadapters. Ein Objektiv bildet dieses Muster auf die Oberfläche des flüssigen Photopolymers ab, das in einer Wanne 5 bereitgehalten wird. Verfahrensvarianten ergeben sich beispielsweise durch den Einsatz eines Zoom-Objektivs, mit dem die optimale Vergrößerung werkstückspezifisch eingestellt werden kann. Die Belichtung größerer Objektquerschnitte wie bei einem Adapter kann schrittweise in Teilbelichtungen erfolgen.

Nachdem die erste, also im beschriebenen Beispiel unterste Querschnittsschicht des Adapters auf diese Weise hergestellt worden ist, wird sie im flüssigen Photopolymer nach unten abgesenkt, und die nächste, darüberliegende Querschnittsschicht des Adapters wird dann auf die vorhergehende erste Schicht belichtet und ausgehärtet - und so weiter, bis der gewünschte Adapter bis zur vorgesehenen Sollstärke fertig ausgeformt ist. Danach wären dann noch eventuelle Nachbearbeitungen des STL-Adapters durchzuführen, soweit erforderlich.

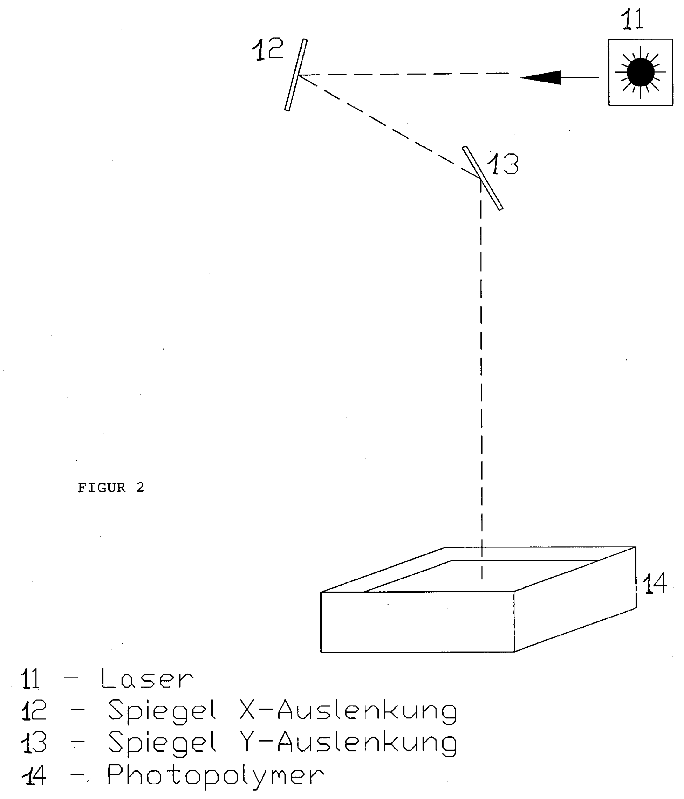

Die Fig. 2 zeigt eine zweite Ausführungsform des Verfahrens. Dabei erfolgt die selektive und schichtweise Aushärtung des flüssigen Photopolymers in der Wanne 14 über zwei z.B. rechnergesteuerte Ablenkspiegel 12 und 13 (jeweils für die Ablenkung in der X- und Y-Richtung). Diese Spiegel ermöglichen es, einen aus einem Laser 11 austretenden Strahl je nach Bedarf über die Oberfläche des flüssigen Photopolymers auszulenken und derart den schichtweisen Aufbau eines STL-Adapters zu gestalten.

Die Fig. 3 zeigt eine alternative Möglichkeit zum Ausbilden der elektrischen Verbindungen durch den STL-Adapter hindurch: Anstatt herkömmliche Prüfstifte aus Metall in die fertigen Prüfstiftkanäle einzusetzen, werden diese mit einem zunächst fließfähigen elektrisch leitfähigen Material befüllt, das anschließend aushärtet: Indem man dabei für einen gewissen Überstand des elektrisch leitfähigen Materials im Bereich der Deck- und Bodenfläche des Adapters sorgt, erreicht man eine gute Kontaktierung der zu prüfenden Leiterplatte bzw. des zu prüfenden Boards einerseits und der Kontakte des Prüfgerätes andererseits, wie dies in der Adaptertechnik üblich ist.

## Patentansprüche

1. Verfahren zur Herstellung eines Adapters zur Anpassung des gleichmäßigen Kontaktrasters einer elektrischen Prüfvorrichtung für Leiterplatten an die ungleichmäßige Kontaktkonfiguration der Anschlußpunkte auf einer ein- oder beiseitig zu prüfenden Leiterplatte mit nadelartigen Prüfstiften, die mit ihrem Ende auf den regelmäßig verteilten Kontakten des Kontaktfeldes der Prüfvorrichtung aufliegen, sich durch die Prüfstiftkanäle des Adapterkörpers erstrecken und mit ihren anderen Enden die meistens unregelmäßig verteilten Anschlußpunkte der zu prüfenden Leiterplatte kontaktieren, wobei die Deckfläche des Adapterkörpers an der zu kontaktierenden Fläche der Leiterplatte und die Bodenfläche des Adapterkörpers auf dem Kontaktfeld der Prüfvorrichtung anliegt und der Adapterkörper im Bereich zwischen seiner Bodenfläche und seiner Deckfläche durchgängig von den Prüfstiftkanälen durchsetzt ist, **dadurch gekennzeichnet, daß** der Adapterkörper mit allen darin erforderlichen Prüfstiftkanälen schichtweise von unten nach oben (oder umgekehrt) aufgebaut wird aus einem Bad eines zunächst flüssigen, aber durch Licht aushärtbaren Photopolymers, wobei die Oberfläche des Bades von einer Lichtquelle in ausgewählten Bereichen belichtet und ausgehärtet wird, und daß diese Schritte sukzessive wiederholt werden, bis alle Schichten des vollständigen Adapters mit sämtlichen, womöglich schräg oder gekrümmt verlaufenden Prüfstiftkanälen aufgebaut sind.

2. Verfahren nach Anspruch 1, **dadurch gekennzeichnet, daß** die ausgewählten Bereiche bestimmt werden durch im optischen Strahlengang des Lichtes angeordneten Photomasken, die der (jeweiligen) Querschnittsfläche des Adapterkörpers einschließlich aller Prüfstiftkanäle entsprechen, wobei die jeweils nächstfolgende Schicht auf der vorhergehenden Schicht belichtet und ausgehärtet wird und die folgende Photomaske sich von der vorhergehenden Photomaske insbesondere durch die Position der Prüfstiftkanäle unterscheiden kann.

3. Verfahren nach Anspruch 2, **dadurch gekennzeichnet, daß** jede der Photomasken von einem LCD (Liquid Crystal Device) gebildet wird, welcher von einem Rechner gesteuert ist zum sukzessiven Errechnen der höhenabhängigen jeweiligen Position der Querschnittsfläche eines jeden Prüfstiftkanals in den jeweiligen Schichten bei beliebig verlaufenden Prüfstiftkanälen des Adapters.

4. Verfahren nach einem der voranstehenden Ansprüche, **dadurch gekennzeichnet, daß** pro Schritt Schichtdicken von 100-200 µm aufgebaut werden.

5. Verfahren nach Anspruch 1, **dadurch gekennzeichnet, daß** die ausgewählten Bereiche bestimmt werden durch einen über das Photopolymer geführten Laserstrahl, der die (jeweiligen) Querschnittsfläche des Adapterkörpers einschließlich aller Prüfstiftkanäle im Bad aushärtet, wobei die jeweils nächstfolgende (aufsteigende) Schicht auf der vorhergehenden Schicht belichtet und ausgehärtet wird und die folgende Schicht sich von der vorhergehenden Schicht insbesondere durch die Position der Prüfstiftkanäle unterscheiden kann.

6. Verfahren nach Anspruch 5, **dadurch gekennzeichnet, daß** der Laserstrahl von einem Ablenkspiegel gesteuert wird.

7. Verfahren nach Anspruch 5 oder 6, **dadurch gekennzeichnet, daß** der Laserstrahl bzw. der Ablenkspiegel von einem Rechner gesteuert wird zum sukzessiven Bestimmen der höhenabhängigen jeweiligen Position der Querschnittsfläche eines jeden Prüfstiftkanals in den jeweiligen Schichten bei beliebig verlaufenden Prüfstiftkanälen des Adapters.

8. Verfahren nach einem der voranstehenden Ansprüche, **dadurch gekennzeichnet, daß** in ausgewählten Bereichen jeder Adapterschicht keine Aushärtung stattfindet zur Ausbildung von Material-Aussparungen , z.B. in Form einer Wabenstruktur innerhalb des Adapters zwischen den Prüfstiftkanälen.

9. Verfahren nach einem der voranstehenden Ansprüche, **dadurch gekennzeichnet, daß** in die derart hergestellten Prüfstiftkanäle jeweils ein Prüfstift eingesetzt wird.

10. Verfahren nach einem der voranstehenden Ansprüche 1-8, **dadurch gekennzeichnet, daß** in die derart hergestellten Prüfstiftkanäle jeweils ein aushärtbares elektrisch leitfähiges Material zur Ausbildung einer prüfstiftartigen Verbindung zwischen der Boden- und Deckfläche des Adapters eingespritzt wird.
